# EUROPÄISCHE PATENTSCHRIFT

(11) **EP 1 748 501 B1**
(45) Veröffentlichungstag und Bekanntmachung des Hinweises auf die Patenterteilung: **17.10.2007**
(21) Anmeldenummer: 05016200.7
(22) Anmeldetag: 26.07.2005
(51) Int. Cl.: H01L 45/00, H01L 49/00

(54) **Mikroelektronisches Bauelement**
Microelectronic component
Composant micro-électronique

(43) Veröffentlichungstag der Anmeldung: 31.01.2007
(73) Patentinhaber: Universität Duisburg-Essen, 45141 Essen (DE)
(72) Erfinder: Schmid, Günter, Prof. Dr., 42555 Velbert (DE); Jäger, Dieter, Prof. Dr., 47269 Duisburg-Rahm (DE); Santhanam, Venugopal, Dipl.-Chem., R.M.V. II Stage, Bangalore 560094 (IN); Simon, Ulrich, Prof. Dr., 52054 Aachen (DE); Torsten, Reuter, 45128 Essen (DE)
(74) Vertreter: Gesthuysen, von Rohr & Eggert

(56) Entgegenhaltungen:
- EP-A- 0 836 232
- WO-A-00/41247
- DE-A1- 4 212 220
- DE-A1- 10 245 554
- DE-C1- 19 621 994
- US-A1- 2004 166 673
- HUANG S ET AL: "CONTROL OF INTERDOT SPACE AND DOT SIZE IN A TWO-DIMENSIONAL GOLD NANODOT ARRAY" JAPANESE JOURNAL OF APPLIED PHYSICS, JAPAN SOCIETY OF APPLIED PHYSICS, TOKYO, JP, Bd. 38, Nr. 4B, PART 2, 15. April 1999 (1999-04-15), Seiten L473-L476, XP000912797 ISSN: 0021-4922
- SCHMID G ET AL: "METAL CLUSTERS AND COLLOIDS" ADVANCED MATERIALS, WILEY VCH, WEINHEIM, DE, Bd. 10, Nr. 7, 7. Mai 1998 (1998-05-07), Seiten 515-526, XP000766708 ISSN: 0935-9648
- WU C S ET AL: "SINGLE-ELECTRON TRANSISTORS AND MEMORY CELLS WITH AU COLLOIDAL ISLANDS" APPLIED PHYSICS LETTERS, AIP, AMERICAN INSTITUTE OF PHYSICS, MELVILLE, NY, US, Bd. 81, Nr. 24, 9. Dezember 2002 (2002-12-09), Seiten 4595-4597, XP001144733 ISSN: 0003-6951

## Beschreibung

Die vorliegende Erfindung betrifft ein mikroelektronisches Bauelement gemäß dem Oberbegriff des Anspruchs 1, eine Verwendung von Clustern gemäß dem Oberbegriff des Anspruchs 12 und ein Verfahren zur Herstellung eines mikroelektronischen Bauelements gemäß dem Oberbegriff des Anspruchs 15.

Aus der DE 42 12 220 A1 und der US 5,350,930 A ist ein mikroelektronisches Bauelement mit mindestens einem Cluster bekannt. Es werden Mikro-Quantenkanäle aus mindestens zwei, vorzugsweise vielen aneinanderliegenden Clustern gebildet. Die Quantenkanäle können sich zwischen Anschlußelektroden erstrecken. Vorzugsweise wird eine Schüttung aus den Clustern verwendet, die zusammengepreßt werden. Die Cluster weisen jeweils einen metallischen Clusterkern und eine isolierende Ligandenhülle auf. Die Clusterkerne weisen insbesondere jeweils 55 Goldatome in dichtester Kugelpackung auf. Mit dem bekannten Bauelement soll eine weitere Miniaturisierung auf dem Gebiet der Mikroelektronik gelingen. Gegenüber dem üblichen Platzbedarf von etwa 250 nm für Transistoren in bisher bekannter Technik können die Abmessungen für die Quantendrähte des bekannten Bauelements wesentlich reduziert werden.

Auf dem Gebiet der Metallcluster mit insbesondere 55 Goldatomen wurde des weiteren intensiv geforscht. Beispielhaft wird hierzu auf folgende Artikel verwiesen: "Single-electron tunneling in Au₅₅ cluster monolayers" von L. F. Chi et al, Appl. Phys. A 66, S.187-190 (1998); "Metal Clusters and Colloids", Günter Schmid et al, Adv. Mater. 1998, 10, No. 7; "Reduced Metallic Properties of Ligand-Stabilized Small Metal Clusters", Huijing Zhang et al, NANO LETTERS 2003, Vol. 3, No. 3, 305-307.

Die DE 102 45 554 A1 offenbart ein Speicherelement, das als Speichermedium ein Dielektrikum enthält, in welchem isolierte Nanopartikel angeordnet sind. Das Dielektrikum wird vorzugsweise von einem organischem Polymer gebildet. Das Speicherelement zeigt einen resistiven Effekt. Unterhalb einer Haltespannung wird das Speicherelement in den gering leitenden Zustand geschaltet, während es oberhalb einer kritischen Spannung in den leitenden Zustand übergeht. Durch Anlegen einer Spannung, welche zwischen der Haltespannung und der kritischen Spannung liegt, kann der Leitungszustand des Speicherelements ausgelesen werden.

Die WO 00/41247 betrifft elektronische Bauelemente mit Quantendimensionen und deren Betriebsbedingungen. Die Vorrichtungen weisen Elektroden und zumindest einen Cluster auf, der von den Elektroden durch eine tunnel-transparente Barriere getrennt ist. Die Cluster können aus einem Halbleitermaterial, Leiter, Supraleiter, einer hochmolekularen Substanz oder einer Abdeckung mit einem tunnel-transparenten Dielektrikum hergestellt sein. Die Vorrichtungen sind in einem Betriebsmodus zur Übertragung und/oder zum Speichern von vielen Elektronen bei normalen Bedingungen und hohen Temperaturen ausgelegt. Insbesondere werden die grundlegenden Bedingungen zum Aufbau von hochtemperatursupraleitenden Komponenten und Bauteilen angegeben. Insbesondere wird eine Größe von 7,25 nm als fundamentale untere Grenze für eine aus Clustern gebildete logische Zelle angegeben.

Der vorliegenden Erfindung liegt die Aufgabe zugrunde, ein mikroelektronisches Bauelement, eine Verwendung von Clustern mit metallischen Clusterkernen und ein Verfahren zur Herstellung eines mikroelektronischen Bauelements anzugeben, wobei ein mikroelektronisches Bauelement, insbesondere in Form eines elektronischen Speichers bzw. mit Ein-Elektronen-Tramistoren, realisierbar ist, das einen minimalen Platzbedarf sowie einen minimalen Strom- und Energiebedarf hat und einfach herstellbar ist und insbesondere bei Raumtemperatur arbeitet.

Die obige Aufgabe wird durch ein mikroelektronisches Bauelement gemäß Anspruch 1, eine Verwendung von Clustern gemäß Anspruch 12 oder ein Verfahren gemäß Anspruch 15 gelöst. Vorteilhafte Weiterbildungen sind Gegenstand der Unteransprüche.

Eine wesentliche Idee der vorliegenden Erfindung liegt darin, Cluster einzelweise derart elektrisch anzuschließen, daß diese unabhängig voneinander einzelweise elektrisch modifizierbar, insbesondere durch einen Ein-Elektronen-Übergang, sind und/oder deren elektrischer Zustand abfragbar ist.

Das einzelweise elektrische Modifizieren und Abfragen gestattet eine Adressiebung, so daß ein elektronischer Speicher mit einer Vielzahl von durch die angeschlossenen Cluster gebildeten "Speicherzellen" bzw. Transistoren realisierbar ist.

Dadurch, daß für jede Speicherzelle bzw. Transistor nur ein einziger Cluster erforderlich ist, wird der Raumbedarf minimiert.

Der idealerweise vorgesehene Ein-Elektronen-Übergang zur Änderung des elektrischen bzw. elektronischen Zustands eines angeschlossenen Clusters minimiert den erforderlichen Strom- und Energiebedarf, so daß sehr schnelle Schaltzeiten realisierbar sind und die gegenüber herkömmlichen Lösungen geringe Verlustwärme eine Miniaturisierung ohne Kühlprobleme und insbesondere einen Einsatz bei Raumtemperatur oder höheren Temperaturen ermöglicht.

Bei den bevorzugten, später noch detaillierter beschriebenen Ausführungsformen werden nicht alle Cluster elektrisch angeschlossen, vielmehr stehen nur einige der Cluster jeweils mit einer ersten und zweiten Anschlußelektrode in Kontakt. Die nicht angeschlossenen Cluster stören dabei nicht.

Weiter können auch fehlerhafte Verbindungen insoweit vorhanden sein, als zwei Anschlußelektroden an einem Kreuzungspunkt anstelle eines dazwischen liegenden Clusters parallel zwei nebeneinanderliegende Cluster kontaktieren. Die Wahrscheinlichkeit derartiger Fehler ist jedoch bei einer vorzugsweise im wesentlichen dem mittleren Clusterdurchmesser entsprechenden Breite der Anschlußelektroden ausreichend niedrig oder sogar vernachlässigbar.

Vorzugsweise werden die Cluster im wesentlichen linien- bzw. reihenförmig angeordnet. Gemäß einer bevorzugten Ausführungsform wird dies sehr einfach dadurch ermöglicht, daß die Cluster in parallelen Nuten mit gleicher Größe aufgenommen werden.

Ein sehr einfacher Aufbau und eine sehr einfache Kontaktierung werden vorzugsweise dadurch erreicht, daß die ersten und zweiten Anschlußelektroden streifenartig ausgebildet und derart angeordnet werden, daß die ersten Anschlußelektroden jeweils parallel zueinander verlaufen und die zweiten Anschlußelektroden jeweils parallel zueinander und quer zu den ersten Anschlußelektroden verlaufen, wobei eine erste und eine zweite Anschlußelektrode an ihrem jeweiligen Kreuzungspunkt jeweils über vorzugsweise einen einzigen Cluster miteinander elektrisch in Kontakt stehen.

Weitere Vorteile, Merkmale, Eigenschaften und Aspekte der vorliegenden Erfindung ergeben sich aus den Ansprüchen und der nachfolgenden Beschreibung bevorzugter Ausführungsformen anhand der Zeichnung. Es zeigt
- Fig. 1: eine schematische perspektivische Darstellung eines vorschlagsgemäßen mikroelektronischen Bauelements mit einer Vielzahl von Clustern gemäß einer ersten Ausführungsform;
- Fig. 2: eine schematische Schnittdarstellung eines Clusters mit zugeordneten Anschlußelektroden des mikroelektronischen Bauelements gemäß der ersten Ausführungsform;
- Fig. 3: eine schematische Darstellung des Herstellungsprozesses eines Werkzeugs für die Herstellung des mikroelektronischen Bauelements gemäß der ersten Ausführungsform;
- Fig. 4: eine schematische Darstellung des Herstellungsprozesses des mikroelektronischen Bauelements gemäß der ersten Ausführungsform;
- Fig. 5: eine schematische explosionsartige Darstellung eines vorschlagsgemäßen mikroelektronischen Bauelements gemäß einer zweiten Ausführungsform; und
- Fig. 6: eine schematische Darstellung einer bevorzugten Herstellung des mikroelektronischen Bauelements gemäß der zweiten Ausführungsform.

In den Figuren werden für gleiche oder ähnliche Teile dieselben Bezugszeichen verwendet, wobei entsprechende oder vergleichbare Eigenschaften und Vorteile erreicht werden, auch wenn eine wiederholte Beschreibung insbesondere aus Vereinfachungsgründen weggelassen ist

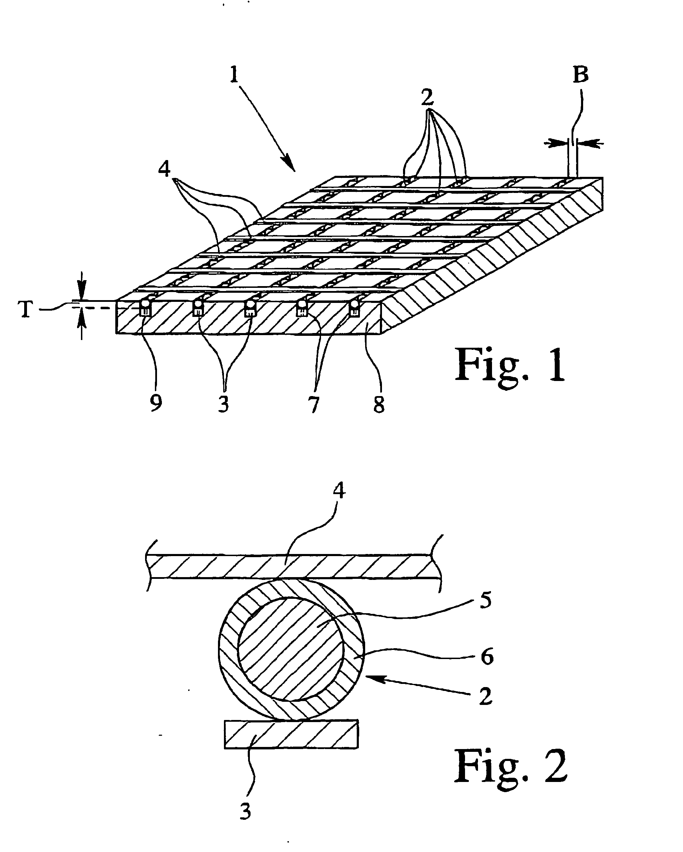

Fig. 1 zeigt in schematischer, perspektivischer Darstellung ein mikroelektronisches Bauelement 1 gemäß einer ersten Ausführungsform. Insbesondere handelt es sich hierbei um einen elektronischen Speicher mit einer Vielzahl von Speicherzellen bzw. Transistoren, vorzugsweise Ein-Elektronen-Transistoren. Jedoch kann das mikroelektronische Bauelement 1 auch für sonstige Zwecke genutzt werden.

Das mikroelektronische Bauelement 1 weist eine Vielzahl von Clustern 2 auf, die in Fig. 1 kugelartig dargestellt sind.

Das mikroelektronische Bauelement 1 weist ferner erste und zweite Anschlußelektroden 3, 4 zum elektrischen Anschluß bzw. zur Kontaktierung von Clustern 2 auf. Hierauf wird später noch näher eingegangen.

Fig. 2 zeigt in schematischer Schnittdarstellung den bevorzugten Aufbau eines Clusters 2. Der Cluster 2 weist einen metallischen Clusterkern 5 und eine vorzugsweise elektrisch isolierende Clusterhülle 6 auf.

Der Clusterkern 5 besteht vorzugsweise aus einem Übergangsmetall, insbesondere Gold. Jeder Clusterkern 5 besteht aus mehreren Metallatomen, insbesondere mindestens 20 und/oder höchstens 100 Metallatomen, ganz besonders bevorzugt 55 Metallatomen, die insbesondere mehrschalig in dichtester Kugelpackung angeordnet sind.

Die Clusterkerne 5 können jedoch auch aus einer anderen Zahl von Atomen aufgebaut sein, insbesondere wenn jeder Clusterkern 5 aus mehreren Übergangsmetallen besteht.

Die Größe der Clusterkerne 5 beträgt höchstens etwa 2,5 nm, insbesondere höchstens etwa 2,0 nm, besonders bevorzugt höchstens 1,6 nm und mindestens etwa 0,5 nm, insbesondere mindestens etwa 1,0 nm, besonders bevorzugt mindestens etwa 1,3 nm. Besonders bevorzugt ist, wenn die mittlere Größe der Clusterkerne 5 im Bereich von etwa 1,3 nm bis etwa 1,5 nm liegt.

Die Clusterhülle 6 ist vorzugsweise elektrisch isolierend ausgebildet und aus organischen Verbindungen aufgebaut. Jedoch kann die Clusterhülle 6 beispielsweise auch aus anorganischen Verbindungen und/oder aus einem anderen Metall gebildet sein.

Vorzugsweise besteht die Clusterhülle 6 aus geeigneten Liganden, beispielsweise aus organischen Resten oder Halogenen, insbesondere Chlor. Beispiele für geeignete organische Verbindungen sind Triphenylphosphine und dessen Derivate.

Die Cluster 2 - also Clusterkern 5 und Clusterhülle 6 - weisen einen mittleren Durchmesser von 1 bis 5 nm, insbesondere 2 bis 3 nm, ganz besonders bevorzugt von im wesentlichen 2,5 nm auf.

Besonders bevorzugt werden Cluster 2 mit folgender Formel:

Au₅₅[P(C₆H₅)₃]₁₂Cl₆

Die Herstellung der Cluster 2 ist der Literatur ohne weiteres zu entnehmen. Insbesondere wird diesbezüglich auf die eingangsseitig genannten Artikel und die darin genannten Zitatstellen verwiesen. Im übrigen können die Cluster 2 in modifizierter Form (mit anderer Clusterhülle 6) auch ohne weiteres käuflich erworben werden, beispielsweise unter dem Handelsnamen Nanogold von der Firma Nanoprobe, USA.

Fig. 2 veranschaulicht weiter, daß der dargestellte Cluster 2 sowohl an eine erste Anschlußelektrode 3 als auch eine zweite Anschlußelektrode 4 angeschlossen ist. Dies stellt die ideale bzw. gewünschte Konfiguration dar und bildet insbesondere eine "Speicherzelle" bzw. eine einzelne elektronische Funktionseinheit einer Vielzahl gleichartiger Funktionseinheiten des mikroelektronischen Bauelements 1.

Die elektronischen Eigenschaften des Clusterkerns 5 bzw. des Clusters 2 entsprechen nicht denen eines Metalls, sondern eher denen eines Halbleiters. So ergibt sich eine Art "Leiter-Halbleiter-Leiter"-Kontakt. Der Cluster 2 bildet mit den Anschlußelekiroden 3, 4 jeweils einen Tunnelkontakt. Dementsprechend können Elektronen zwischen den Anschlußelektroden 3, 4 und dem Cluster 2 fließen. Insbesondere genügen Ein-Elektronen-Übergänge, um den elektrischen Zustand des Clusters 2 zu ändern. Dementsprechend kann mit der genannten Konfiguration eine Art "Ein-Elektronen-Transistor" - also eine vorzugsweise mit nur einem einzigen Elektron schaltende Speicherzelle bzw. Schaltung - gebildet werden.

Wie in Fig. 2 dargestellt, ist grundsätzlich vorgesehen, daß der Cluster 2 einzeln jeweils an eine erste und zweite Anschlußelektrode 3, 4 angeschlossen sind. Insbesondere sollen eine erste und eine zweite Anschlußelektrode 3, 4 grundsätzlich jeweils nur über höchstens ein Cluster 2 miteinander elektrisch in Kontakt stehen. So werden eine optimale Miniaturisierung und ein einfacher Aufbau sowie ein geringer Strom- und Energiebedarf ermöglicht.

Bedarfsweise können den angeschlossenen Clustern 2 zusätzlich auch nicht dargestellte Steuerelektroden, wie bei Transistoren üblich, zugeordnet sein.

Die Cluster 2 sind linien- oder reihenartig, insbesondere nur in einer Ebene, angeordnet, wie in Fig. 1 dargestellt. Insbesondere sind die Cluster 2 hierzu in entsprechend angeordneten und ausgebildeten Nuten 7 in einem Träger 8 des mikroelektronischen Bauelements 1 aufgenommen.

Die Nuten 7 sind beim Darstellungsbeispiel im Querschnitt im wesentlichen rechteckig ausgebildet und weisen ggf. einen gekrümmten Nutboden 9 auf. Dies hängt insbesondere auch von dem Herstellungsverfahren ab, worauf später noch näher eingegangen wird.

Die Breite B der Nuten 7 ist möglichst gering, so daß die Cluster 2 möglichst nur in einer Reihe und nicht nebeneinander in die Nuten 7 passen. Vorzugsweise beträgt die Breite B der Nuten 7 maximal 5 nm, insbesondere maximal 4 nm, vorzugsweise etwa 3 nm.

Vorzugsweise beträgt der Durchmesser der Cluster 2 mindestens 50 %, insbesondere mindestens 70 %, der Breite B der Nuten 7. Dies führt zu der im Idealfall zumindest weitgehend geradlinigen Kette von Clustern 2 in den Nuten 7.

Beim Darstellungsbeispiel sind die ersten Anschlußelektroden 3 in den Nuten 7 angeordnet, insbesondere unmittelbar auf den Nutböden 9 bildet. Die verbleibende lichte Tiefe T der Nuten 7 beträgt vorzugsweise maximal 3 nm, insbesondere 2 nm. Insbesondere ist die lichte Tiefe T geringer als der mittlere Durchmesser der Cluster 2. So wird erreicht, daß die in den Nuten 7 aufgenommenen Cluster 2 aus den Nuten 7 etwas vorragen, um die elektrisch Kontaktierung mit den vorzugsweise quer zu den Längsrichtungen der Nuten 7 verlaufenden zweiten Anschlußelektroden 4 zu erleichtern.

Die ersten Anschlußelekroden 3 verlaufen beim Darstellungsbeispiel parallel zueinander und in einer gemeinsamen Ebene.

Die zweiten Anschlußelektroden 4 verlaufen beim Darstellungsbeispiel ebenfalls parallel zueinander in einer gemeinsamen Ebene und quer, insbesondere senkrecht, zu den ersten Anschlußelektroden 3 bzw. den Clusterreihen oder Nuten 7.

Um die bereits anhand von Fig. 2 erläuterte einzelweise Kontaktierung der Cluster 2 zu erreichen, entspricht der Abstand der Ebenen der ersten und zweiten Anschlußelektroden 3, 4 etwa dem mittleren Durchmesser der Cluster 2.

Der Abstand zwischen den Nuten 7 bzw. Clusterreihen 2 ist vorzugsweise möglichst gering. Insbesondere beträgt er 3 bis 100 nm, vorzugsweise etwa 5 bis 60 nm. Entsprechendes gilt für den Abstand zwischen den zweiten Anschlußelektroden 4.

Die zweiten Anschlußelektroden 4 sind jeweils vorzugsweise im wesentlichen steg- oder streifenartig ausgebildet. Die Breite B ist möglichst gering und beträgt vorzugsweise maximal 4 nm. Sie beträgt insbesondere im wesentlichen 2,5 oder 3 nm oder insbesondere im wesentlichen etwa 50 bis 125 % des mittleren Durchmessers der Cluster 2. So kann erreicht werden, daß die zweiten Anschlußelektroden 4 jeweils möglichst nur einen einzigen Cluster 2 einer Nut 7 kontaktieren. Sofern gleichzeitig zwei Cluster 2 in einer Nut 7 von einer zweiten Anschlußelektrode 4 kontaktiert werden, handelt es sich um eine Fehlstelle bzw. fehlerhafte Speicherzelle.

Die genannte Breite B für die zweiten Anschlußelektroden 4 gilt vorzugsweise auch für die ersten Anschlußelektroden 3, insbesondere wenn die Cluster 2 auf frei zugänglichen ersten Anschlußelektroden 3, also nicht in den Nuten 7, angeordnet werden, wie später noch bei einer zweiten Ausführungsform der vorliegenden Erfindung erläutert.

Wie bereits eingangs schon erläutert, werden bei dem dargestellten Ausführungsbeispiel nicht alle Cluster 2 kontaktiert, sondern lediglich diejenigen im Bereich der Kreuzungspunkte zwischen den ersten und zweiten Anschlußelektroden 3, 4. Die weiteren, nicht kontaktierten Cluster 2 sind für die Funktion des mikroelektronischen Bauelements 1 insbesondere dann unkritisch, wenn in einer Nut 7 zwischen zwei benachbarten, angeschlossenen Clustern 2 mehrere nicht angeschlossene Cluster 2 in der Nut 7 vorhanden sind.

Alternativ oder zusätzlich ist es natürlich auch möglich, daß zwischen den jeweils angeschlossenen Clustern 2 in einer Nut 7 keine weiteren Cluster 2 angeordnet sind oder die Kette der Cluster 2 jeweils unterbrochen ist, beispielsweise durch nachträgliches Lösen oder Modifizieren von nicht kontaktierten Clustern 2 oder durch entsprechende, vorzugsweise einzelweise Positionierung von Clustern 2 in geeigneten, nicht dargestellten Ausnehmungen und Vertiefungen, die beispielsweise durch anodische Oxidation von Aluminium erzeugbar sind.

In Fig. 1 sind nur die wesentlichen Strukturen des mikroelektronischen Bauelements 1 gemäß der besonders bevorzugten Ausführungsform dargestellt, um das Prinzip des vorgeschlagenen Aufbaus zu verstehen. Selbstverständlich sind statt dessen andere konstruktive Lösungen und Anordnungen möglich.

Wesentlich ist, daß eine Vielzahl der Cluster 2 einzeln jeweils an eine erste und zweite Anschlußelektrode 3, 4 derart angeschlossen sind, daß diese Cluster 2 unabhängig voneinander einzelweise elektrisch modifizierbar oder abfragbar sind. Insbesondere ermöglicht die vorschlagsgemäße Lösung auch eine einfache Adressierung der angeschlossenen Cluster 2 bzw. gebildeten Speicherzellen.

Zur Modifikation des elektronischen Verhaltens bzw. Steuerung können zusätzlich auch nicht dargestellte Steuerelektroden od. dgl. den angeschlossenen Clustern 2 zugeordnet sein.

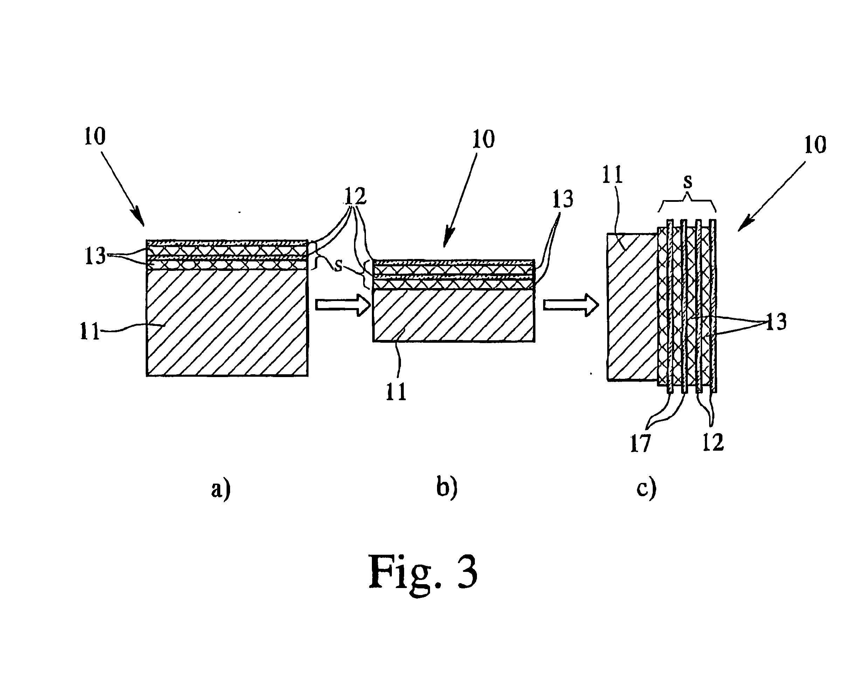

Nachfolgend wird die Herstellung des mikroelektronischen Bauelements 1 gemäß der ersten Ausführungsform näher erläutert. Hierzu wird zunächst anhand von Fig. 3 die Herstellung eines Werkzeugs 10 beschrieben.

Bei der Herstellung des Werkzeugs 10 wird die Möglichkeit genutzt, Schichten definierter Dicke, beispielsweise durch MBE (Molecular Beeam Epitaxy), sonstige Epitaxie oder sonstige geeignete Verfahren, zu erzeugen und diesen definierten Dicken für die Herstellung erforderlicher Streifenstrukturen zu verwenden.

Wie in Fig. 3 angedeutet, werden in Schritt a) auf ein Substrat 11, beispielsweise mit GaAs dotiertes Si, abwechselnd Schichten 12, 13 aus unterschiedlichem Material, insbesondere abwechselnd GaAs und AlAs, erzeugt. Insbesondere weisen die beim Darstellungsbeispiel aus AlAs bestehenden dünneren Schichten 12 eine Dicke von vorzugsweise nur etwa 2 bis 3 nm, insbesondere im wesentlichen 2,5 nm, auf. Die Dicke der dickeren Schichten 13, die hier aus GaAs bestehen, beträgt etwa 5 bis 100 nm. Beispielsweise werden 20 oder bis über 1000 derartige Schichtpaare nacheinander, insbesondere durch MBE, aufgebracht. So wird eine Schichtstruktur S gebildet.

Anschließend wird in Schritt b) mindestens eine Seitenfläche geläppt und anschließend einem selektiven Materialabtrag, insbesondere durch Ätzen, unterzogen (beim Darstellungsbeispiel wird vorzugsweise eine Lösung aus Zitronensäure und Wasserstoffperoxyd verwendet), um die dickeren Schichten 13 seitlich derart oder stärker wegzuätzen, daß die dünneren Schichten 12 - beim Darstellungsbeispiel die Schichten 12 aus AlAs - vorstehen, insbesondere um etwa 10 bis 40 nm.

Bedarfsweise kann die Schichtstruktur S bzw. die dünnere oder dickere Schicht 12, 13 oxidiert werden, insbesondere AlAs zu Al₂O₃ und/oder GaAs zu Ga₂O₃. Dies kann der gewünschten Festigkeit des Werkzeugs 10 bzw. der Schichtstruktur S zuträglich sein.

Schritt c) zeigt beispielhaft das dann entstehende Werkzeug 10 mit den seitlich stegartig vorstehenden, dünneren Schichten 12. Das Werkzeug 10 ist dann insbesondere als Stempel bzw. Matrize od. dgl. einsetzbar.

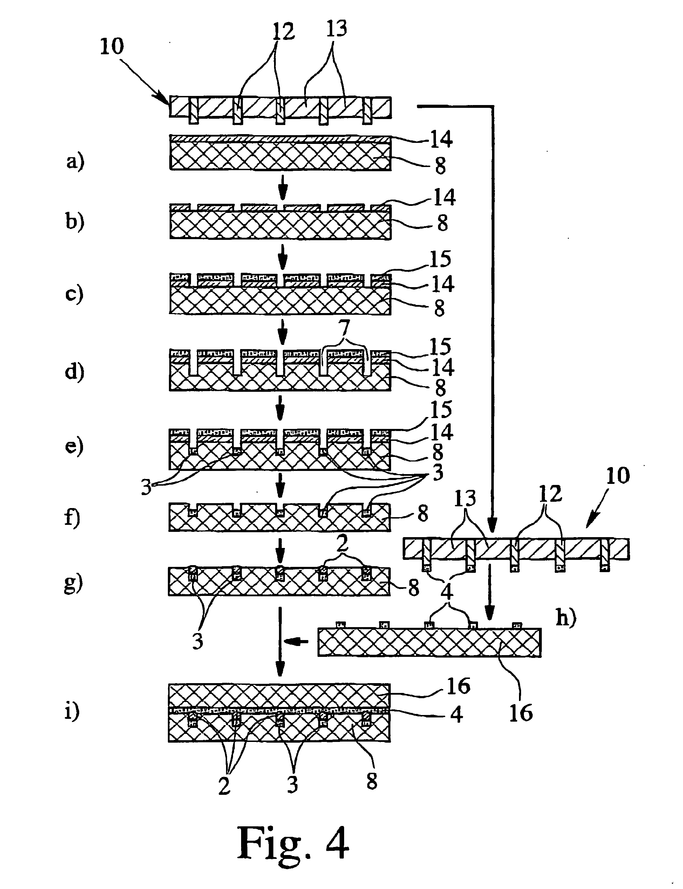

Nachfolgend wird anhand von Fig. 4 ein bevorzugtes Verfahren zur Herstellung des mikroelektronischen Bauelements 1 erläutert.

Der Träger 8 besteht vorzugsweise aus Silizium oder Siliziumdioxid. Insbesondere handelt es sich um einen handelsüblichen Wafer.

Im Schritt a) wird der Träger 8 mit einer geeigneten Beschichtung 14, insbesondere aus einem Polymer, vorzugsweise dem unter dem Handelsnamen "mr-8010" von www.microresist.de erhältlichen Polymer, mit einer Dicke von etwa 20 bis 150 nm versehen. Anschließend wird bei einer erhöhten Temperatur von beispielsweise etwa 180°C das Werkzeug 10 mit den vorspringenden Kanten der Schichten 12 in die Beschichtung 14 gedrückt, beispielsweise mit einer Kraft von 20 bis 40 cN für beispielsweise 1 bis 5 min. Hierbei ist eine korrekte Ausrichtung des Werkzeugs 10 relativ zur Oberfläche des Trägers 8 wesentlich.

Nach dem Trennen des Werkzeugs 10 vom Träger 8 ergeben sich Schlitze bzw. Nuten in der Beschichtung 14 in gewünschten Abständen und mit gewünschter Breite, wie in Schritt b) angedeutet.

Anschließend wird in Schritt c) die Beschichtung 14 mit einer Abdeckschicht 15, vorzugsweise aus Gold, insbesondere durch schräge Bedampfung, um nicht die Nuten 7 zu beschichten, versehen.

Die Abdeckschicht 15 dient als Ätzmaske im nachfolgenden Ätzschritt d). Insbesondere erfolgt ein Trockenätzen. So werden die Nuten 7 im Träger 8 gebildet.

Anschließend werden in Schritt e) die ersten Anschlußelektroden 3 in den Nuten 7 gebildet. Dies kann beispielsweise durch Bedampfen mit einem geeigneten Material, wie Gold oder Palladium, oder in sonstiger geeigneter Weise erfolgen.

Im Schritt f) werden anschließend die Schichten 14 und 15 entfernt, beispielsweise durch Ultraschall und/oder ein geeignetes Lösungsmittel, wie Aceton.

In Schritt g) werden dann die Cluster 2 in den Nuten 7 auf den ersten Anschlußelektroden 3 angeordnet. Dies erfolgt vorzugsweise durch elektrophoretische Abscheidung. Beispielsweise werden die Cluster 2 unmittelbar durch Anlegen einer entsprechenden Spannung auf den ersten Anschlußelektroden 3 abgeschieden. Dabei ist es unerheblich, daß die Cluster 2 unmittelbar miteinander in Kontakt stehen. Vielmehr wird dadurch die gewünschte elektrische Kontaktierung der Cluster 2 mit den ersten Anschlußelektroden 3 auf sehr einfache Art und Weise erreicht. Es kann auch eine selektive Adsorbtion der Cluster 2 auf den ersten Anschlußelektroden 3 erfolgen, insbesondere indem die ersten Anschlußelektroden 3 dazu mit einer Dithiol-Monolayer-Schicht od. dgl. versehen werden.

In Schritt h) werden die zweiten Anschlußelektroden 4 hergestellt. Insbesondere wird hierzu das Werkzeug 10 oder ein sonstiges Werkzeug verwendet Beim Darstellungsbeispiel werden die Kanten der vorstehenden, dünneren Schichten 12 mit einem elektrisch leitenden Material, insbesondere Gold, Paladium, Platin oder dgl., beschichtet, vorzugsweise durch Schräg-Bedampfen od. dgl. So werden die vorzugsweise streifenartigen, zweiten Anschlußelektroden 4 erzeugt.

Vorzugsweise bestehen die ersten Anschlußelektroden 3 einerseits und die zweiten Anschlußelektroden 4 andererseits aus elektrisch unterschiedlichen Materialien bzw. Materialien, insbesondere Metallen und/oder Halbleitermaterialien, unterschiedlicher Elektronegativität, um einen in elektrischer Hinsicht asymmetrischen Aufbau zu erreichen. Jedoch können die Anschlußelektroden 3 auch aus dem gleichen Material, insbesondere einem Edelmetall, einem Übergangsmetall oder einer diesbezüglichen Legierung, bestehen.

Die zweiten Anschlußelektroden 4 werden dann auf einen Elektrodenträger 16, der insbesondere aus einem geeigneten Kunststoff, wie Polydimethylsiloxan od. dgl. besteht, übertragen, indem das Werkzeug 10 auf den Elektrodenträger 16 aufgepreßt wird. Vorzugsweise weist der Elektrodenträger 16 zumindest eine gewisse Elastizität und/oder plastische Verformbarkeit auf. In Schritt h) ist der Elektrodenträger 16 mit bereits übertragenen zweiten Anschlußelektroden 4 dargestellt.

In Schritt i) wird schließlich der Elektrodenträger 16 zusammen mit den zweiten Anschlußelektroden 4 auf den Träger 8 mit den vorzugsweise aus den Nuten 7 etwas vorragenden Clustern 2 aufgepreßt und mit diesem in geeigneter Weise verbunden. Die parallel zueinander verlaufenden, zweiten Anschlußelektroden 4 erstrecken sich dabei quer, insbesondere senkrecht, zu den Clusterreihen bzw. Nuten 7 und damit auch zu den ersten Anschlußelektroden 3. Damit ist dann das vorschlagsgemäße mikroelektronische Bauelement 1 fertiggestellt.

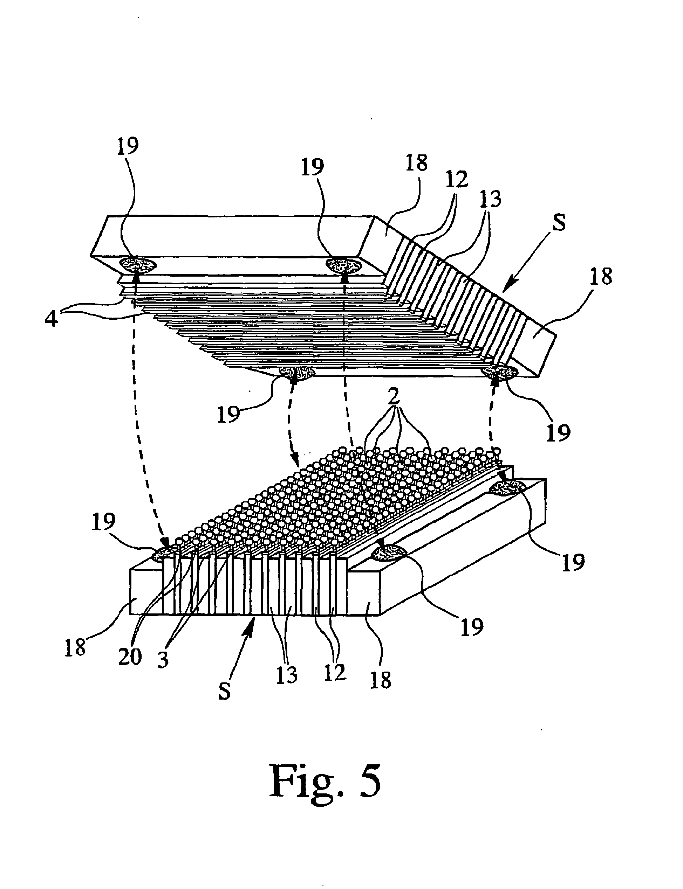

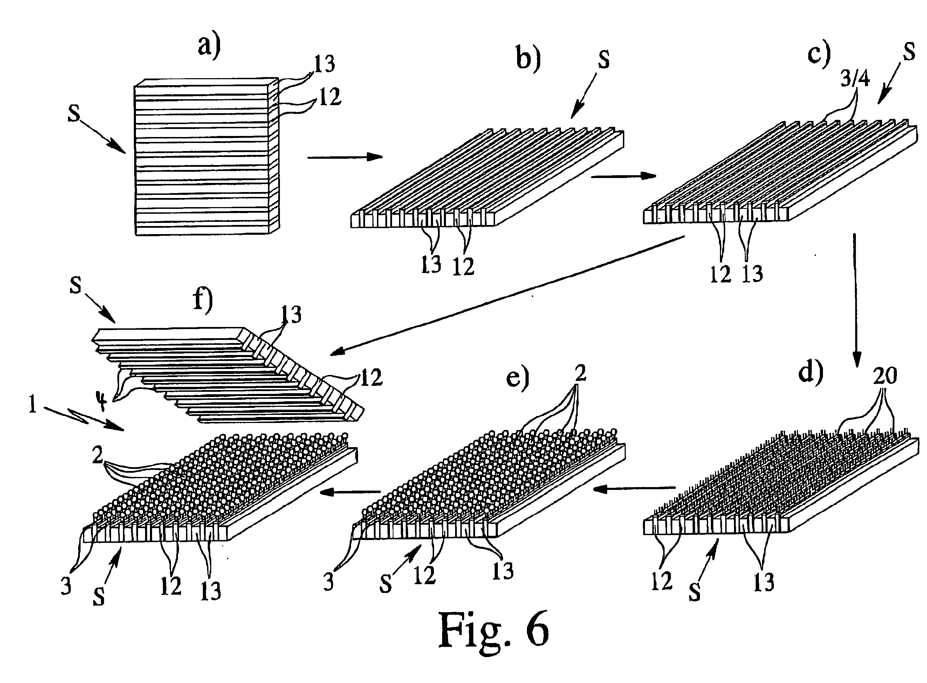

Nachfolgend wird unter Bezugnahme auf Fig. 5 und 6 eine zweite Ausführungsform des vorschlagsgemäßen mikroelektronischen Bauelements 1 und des vorschlagsgemäßen Verfahrens zur Herstellung des mikroelektronischen Bauelements 1 erläutert. Nachfolgend werden primär nur wesentliche Unterschiede gegenüber der ersten Ausführungsform herausgestellt, so daß die bisherigen Erläuterungen und Ausführungen ergänzend oder entsprechend gelten.

Bei der zweiten Ausführungsform sind keine Nuten 7 zur Aufnahme der Cluster 2 und/oder der ersten Anschlußelektroden 3 vorgesehen. Statt dessen sind die ersten Anschlußelektroden 3 bei der Herstellung für die Cluster 2 frei zugänglich.

Die ersten Anschlußelektroden 3 sind wiederum vorzugsweise streifenartig ausgebildet und parallel zueinander, insbesondere in einer gemeinsamen Ebene, angeordnet. Die Breite B der ersten Anschlußelektroden 3 ist vorzugsweise wiederum sehr gering, wie bereits schon bei der ersten Ausführungsform erläutert.

Vorzugsweise sind die ersten Anschlußelektroden 3 auf vorzugsweise vorstehenden Stirnseiten (Schmalseiten) 17 einer Schichtstruktur S, wie in Fig. 3c) angedeutet, insbesondere durch Bedampfen mit Gold, gebildet. Die bevorzugte Herstellung wird später anhand von Fig. 6 im einzelnen erläutert. Jedoch können die ersten Anschlußelektroden 3 auch in jeder sonstigen geeigneten Weise hergestellt werden.

Die Cluster 2 sind vorzugsweise fortlaufend - insbesondere ohne Abstand in Längserstreckung unmittelbar hintereinander linienförmig - auf den ersten Anschlußelektroden 3 angeordnet, wie in Fig. 5 dargestellt. Bei der zweiten Ausführungsform können die Cluster 2 - wie bei der ersten Ausführungsform - durch elektrophoretische Abscheidung oder durch selektive Adsorption auf den ersten Anschlußelektroden 3 angeordnet werden.

Besonders bevorzugt erfolgt die Anordnung der Cluster 2 auf den ersten Anschlußelektroden 3 bzw. die Verbindung der Cluster 2 mit den ersten Anschlußelektroden 3 durch chemische Bindungen, insbesondere kovalente Bindungen und/oder Thiol-Bindungen, zwischen den Clustern 2 bzw. Clusterkernen 5 einerseits und den ersten Auschlußelektroden 3 andererseits. Insbesondere werden hierzu die vorzugsweise aus Gold bestehenden ersten Anschlußelektroden 3 - beispielsweise mit Phenylendithiol - chemisch modifiziert, so daß kovalente Gold-Schwefel-Bindungen zwischen den Anschlußelektroden 3 und den Thiolen und/oder zwischen den Thiolen und den Clustern 2, insbesondere deren vorzugsweise aus Gold bestehenden Clusterkernen 5, gebildet werden können. Insbesondere erfolgt aufgrund der großen Thiophilie von Gold, eine Substitution in der Clusterhülle 6, insbesondere von Triphenylphosphin, um die Thiol-Bindungen mit den Clusterkernen 5 aus Gold herzustellen.

Die voranstehend erläuterte chemische Bindung der Cluster 2 bzw. Clusterkerne 5 an den ersten Anschlußelektronen 3 kann bedarfsweise auch bei der ersten Ausführungsform und/oder alternativ oder zusätzlich hinsichtlich der zweiten Anschlußelektroden 4 realisiert werden.

Bei der zweiten Ausführungsform sind die zweiten Anschlußelektroden 4 vorzugsweise in entsprechender Weise wie die ersten Anschlußelektroden 3 hergestellt, insbesondere also auf den Stirnseiten 17 einer Schichtstruktur S gebildet. Jedoch können die zweiten Anschlußelektroden 4 auch auf jede sonstige geeignete Art und Weise hergestellt, insbesondere auf eine andere Art und Weise als die ersten Anschlußelektroden 3 hergestellt sein.

Die Kontaktierung der zweiten Anschlußelektroden 4 mit den Clustern 2 bzw. den ersten Anschlußelektroden 3 über die dazwischen liegenden Cluster 2 erfolgt vorzugsweise entsprechend der ersten Ausführungsform, insbesondere also durch Aufsetzen der zweiten Anschlußelektroden 4 quer zu den ersten Anschlußelektroden 3, so daß jeweils eine erste und eine zweite Anschlußelektrode 3, 4 an ihrem jeweiligen Kreuzungspunkt insbesondere nur über einen einzigen Cluster 2 - mit Ausnahme der vernachlässigbaren Fehlstellen - unmittelbar miteinander elektrisch in Kontakt gebracht werden.

Bei dem Darstellungsbeispiel gemäß Fig. 5 sind Verbindungsabschnitte 18 seitlich an die beiden Schichtstrukturen S angesetzt, beispielsweise angeklebt. Die Verbindungsabschnitte bestehen vorzugsweise aus einem elektrisch nicht leitenden Material, beispielsweise Glas. Die Verbindungsabschnitte 18 sind gegenüber den Ebenen der Anschlußelektroden 3 bzw. 4 vorzugsweise zurückversetzt. Die Verbindungsabschnitte 18 bilden gegenüber den mikroskopisch kleinen Anschlußelektroden 3, 4 makroskopisch vergrößerte Flächen, um die beiden Schichtstrukturen S mit den Anschlußelektroden 3 bzw. 4 über die Verbindungsabschnitte 18 bzw. deren Flächen miteinander verbinden zu können, insbesondere durch Kleben, beispielsweise mit Klebstoff 19, wie in Fig. 5 angedeutet Besonders bevorzugt verliert der Klebstoff 19, beispielsweise Sekundenkleber, beim Trocknen geringfügig an Volumen, so daß die beiden Anschlußelektrodenanordnungen unter Druck aufeinander zu liegen kommen.

Jedoch können die Teile des vorschlagsgemäßen Bauelements 1 - insbesondere die Schichtstrukturen S mit den Anschlußelektroden 3, 4 und den dazwischen liegenden Clustern 2 auch auf jede sonstige geeignete Art und Weise - bedarfsweise über die dargestellten Verbindungsabschnitte 18 - miteinander verbunden werden, beispielsweise durch Eingießen in Kunststoff oder einem sonstigen geeigneten Material.

Im zusammengebauten Zustand ragen die ersten und zweiten Anschlußelektroden 3, 4 - ggf. mit den Schichtstrukturen S - vorzugsweise über die Verbindungsabschnitte 18 der jeweils gegenüberliegenden Anschlußelektrodenanordnung in Längserstreckung hinaus, um eine Kontaktierung der Anschlußelektroden 3, 4 zu erleichtern.

Das voranstehend erläuterte Verbinden der Teile des Bauelements 1 kann bedarfsweise entsprechend auch bei der ersten Ausführungsform realisiert werden.

Fig. 6 zeigt in einer schematischen Darstellung ein bevorzugtes Verfahren zur Herstellung des mikroelektronischen Bauelements 1 gemäß der zweiten Ausführungsform.

Bei der zweiten Ausführungsform wird die bereits anhand der ersten Ausführungsform erläuterte Schichtstruktur S unmittelbar zur Herstellung der Anschlußelektroden 3 und 4 verwendet. Zunächst wird in Schritt a) die Schichtstruktur S - insbesondere wie bei der ersten Ausführungsform erläutert - gebildet, insbesondere aus abwechselnd dünneren Schichten 12 und dickeren Schichten 13, die vorzugsweise aus AlAs und GaAs bestehen. Vorzugsweise beträgt die Dicke der dünneren Schichten 12 unter 5 nm, insbesondere im wesentlichen nur 2,5 nm.

Anschließend wird in Schritt b) mindestens eine Seitenfläche mechanisch bearbeitet, insbesondere geläppt, und einem selektiven Materialabtrag, vorzugsweise durch Ätzen, unterzogen, um die dickeren Schichten 13 seitlich derart oder stärker abzutragen, daß die dünneren Schichten 12 vorstehen. Zusätzlich erfolgt vorzugsweise ein Oxidieren, wie bereits bei der ersten Ausführungsform erläutert.

In Schritt c) werden die vorzugsweise vorstehenden dünneren Schichten 12 bzw. deren Stirnseiten 17 mit den Anschlußelektroden 3 oder 4 versehen. Dies erfolgt insbesondere durch Bedampfen mit einem geeigneten Material, wie Gold oder Palladium, oder in sonstiger geeigneter Weise. Besonders bevorzugt erfolgt ein schräges Bedampfen, beispielsweise unter einem Winkel von 45° zu den Schichtebenen, um die zurückversetzten dickeren Schichten 13 nicht oder nur in vernachlässigbarer Weise zu bedampfen. Fig. 6c) zeigt die Schichtstruktur S mit den aufgebrachten ersten oder zweiten Anschlußelektroden 3 bzw. 4.

In Schritt d) wird die Schichtstruktur S mit den ersten Anschlußelektroden 3 weiter modifiziert. Insbesondere werden die ersten Anschlußelektroden 3 chemisch modifiziert, beim Darstellungsbeispiel durch Phenylendithiol, wie durch Bezugszeichen 20 angedeutet. Jedoch sind hierzu auch andere chemische Substanzen einsetzbar.

Danach werden die ersten Anschlußelektroden 3 mit den Clustern 2 belegt. Dies erfolgt insbesondere durch Eintauchen in eine Lösung mit den Clustern 2, vorzugsweise eine Dichlormethanlösung. Bei den vorzugsweise aus Gold bestehenden Clusterkernen 5 werden dann dank der großen Thiophilie von Gold kovalente Gold-Schwefel-Bindungen unter Substitution von Triphenylphosphin hergestellt. So kann eine sehr effiziente und gut haltende Belegung der vorzugsweise aus Gold bestehenden ersten Anschlußelektroden 3 mit Clustern 2 erreicht werden, wie in Fig. 6e) dargestellt.

Als nächstes werden die zweiten Anschlußelektroden 4 - die vorzugsweise entsprechend der Schritte a) bis c) auf einer zweiten Schichtstruktur S hergestellt wurden - mit den Clustern 2 in Kontakt gebracht, indem die Anordnung mit den zweiten Anschlußelektroden 4 auf die Clusterreihen aufgesetzt wird. Die ersten und/oder zweiten Anschlußelektroden 3, 4 können zur elektrischen Kontaktierung an die Cluster 2 angepreßt und/oder gegen diese vorgespannt und/oder in dieser die Cluster 2 elektrisch kontaktierenden Lage festgelegt werden, insbesondere relativ zueinander, wie bereits anhand von Fig. 5 erläutert.

Die relative Festlegung der beiden Anordnungen von ersten bzw. zweiten Anschlußelektroden 3, 4 - insbesondere also der beiden Schichtstrukturen S - relativ zueinander kann in jeder geeigneten Art und Weise erfolgen. Das mögliche seitliche Anbringen der Verbindungsabschnitte 18 und deren mögliches Zusammenkleben oder sonstiges Verbinden wurde bei der voranstehenden Beschreibung aus Vereinfachungsgründen weggelassen. Dies kann vom Fachmann jedoch auf verschiedene Art und Weise - je nach Bedarf und gewünschtem Verfahrensablauf- realisiert werden.

Schließlich folgt vorzugsweise eine nicht dargestellte, elektrische Kontaktierung der ersten und zweiten Anschlußelektroden 3 und 4, um die Speicherzellen des vorschlagsgemäßen mikroelektronischen Bauelements 1 in gewünschter Weise elektrisch ansprechen zu können.

Einzelne Aspekte und Merkmale der ersten und zweiten Ausführungsformen und Verfahren können beliebig miteinander kombiniert werden und auch bei sonstigen mikroelektronischen Bauelementen eingesetzt werden.

Die genannten Verfahren sind sehr einfach und kostengünstig durchführbar. Insbesondere gestattet das Verfahren die Herstellung besonders kleiner Strukturen, die bisher praktisch nicht erreichbar waren.

Die vorschlagsgemäßen Verfahren sind auch für die Herstellung anderer mikroelektronischer Bauelemente, ggf. also unabhängig von der Verwendung von Clustern 2 od. dgl., einsetzbar. Dies gilt insbesondere hinsichtlich der Herstellung des Werkzeugs 10 bzw. der Schichtstruktur S und dessen bzw. deren universelle Einsatzmöghchkeiten zur Erzeugung sehr feiner Strukturen mit parallel verlaufenden Rillen, Kanten, Nuten 7, Anschlußelektroden 3, 4 od. dgl.

Bei den Darstellungsbeispielen weist das mikroelektronische Bauelement 1 eine Vielzahl von separat elektrisch ansprechbaren, diodenartigen Speicherzellen bzw. Schaltungen auf, die insbesondere mit Ein-Elektronen-Übergängen arbeiten bzw. schalten. Zur Bildung von Transistoren sind vorzugsweise zusätzlich (nicht dargestellte) Steuerelektroden oder sonstige geeignete Steuerelemente vorgesehen, insbesondere um die ansonsten üblichen Speicherschaltungen oder dgl. zu bilden.

## Patentansprüche

1. Mikroelekrtronisches Bauelement (1), insbesondere elektronischer Speicher, mit mehreren Clustern (2) und mit ersten und zweiten Anschlußelektroden (3, 4), wobei die Cluster (2) jeweils einen metallischen Clusterkern (5) und vorzugsweise eine elektrisch isolierende Clusterhülle (6) aufweisen,
**dadurch gekennzeichnet,**
**daß** eine Vielzahl der Cluster (2) einzeln jeweils an eine erste und zweite Anschlußelektrode (3, 4) derart angeschlossen sind, daß diese Cluster (2) unabhängig voneinander einzelweise elektrisch modifizierbar oder abfragbar sind, und
**daß** die Größe der Clusterkerne (5) höchstens etwa 2,5 nm beträgt und/oder die Cluster (2) einen mittleren Durchmesser von 1 bis 5 nm aufweisen.

2. Bauelement nach Anspruch 1, **dadurch gekennzeichnet, daß** die Cluster (2) linien- oder reihenartig, insbesondere nur in einer Ebene, oder einzeln, insbesondere in Vertiefungen, angeordnet sind.

3. Bauelement nach Anspruch 1 oder 2, **dadurch gekennzeichnet, daß** die zweiten Anschlußelektroden (4) parallel zueinander, insbesondere in einer gemeinsamen Ebene beabstandet zu den ersten Anschlußelektroden (3), verlaufen,

4. Bauelement nach den Ansprüchen 2 und 3, **dadurch gekennzeichnet, daß** die zweiten Anschlußelektroden (4) die Clusterlinien bzw. -reihen kreuzen, insbesondere senkrecht zu diesen verlaufen.

5. Bauelement nach einem der voranstehenden Ansprüche, **dadurch gekennzeichnet, daß** die ersten und/oder zweiten Anschlußelektroden (3, 4) auf Stirnseiten (17) einer Schichtstruktur (S) oder zweier Schichtstrukturen (S) gebildet sind, insbesondere durch Bedampfen, vorzugsweise wobei die Schichtstruktur(en) (S) aus abwechselnden Lagen von einerseits GaAs oder Ga₂O₃ und andererseits AlAs oder Al₂O₃ aufgebaut ist bzw. sind.

6. Bauelement nach einem der voranstehenden Ansprüche, **dadurch gekennzeichnet, daß** die ersten und/oder zweiten Anschlußelektroden (3, 4) zur elektrischen Kontaktierung an die Cluster (2) angepreßt und/oder gegen diese vorgespannt und/oder in der die Cluster (2) kontaktierenden Lage festgelegt sind.

7. Bauelement nach einem der voranstehenden Ansprüche, **dadurch gekennzeichnet, daß** die ersten und/oder zweiten Anschlußelektroden (3, 4) mit den kontaktieren Clustern (2) jeweils einen Tunnelkontakt bilden.

8. Bauelement nach einem der voranstehenden Ansprüche, **dadurch gekennzeichnet, daß** eine erste und zweite Anschlußelektrode (3, 4) zusammen mit einem kontaktierten Cluster (2) jeweils einen Ein-Elektronen-Transistor bilden und/oder über höchstens einen Cluster (2) unmittelbar miteinander elektrisch in Kontakt stehen.

9. Bauelement nach einem der voranstehenden Ansprüche, **dadurch gekennzeichnet, daß** die Breite (B) der ersten und/oder zweiten Anschlußelektroden (3, 4) im wesentlichen 50 bis 125 % des mittleren Durchmessers der Cluster (2) beträgt.

10. Bauelement nach einem der voranstehenden Ansprüche, **dadurch gekennzeichnet, daß** die Cluster (2) oder Clusterkerne (5) chemisch, insbesondere über kovalente Bindungen und/oder Thiol-Bindungen, an die ersten und/oder zweiten Anschlußelektroden (3, 4) gebunden sind.

11. Bauelement nach einem der voranstehenden Ansprüche, **dadurch gekennzeichnet, daß** die Clusterkerne (5) Gold enthalten oder daraus bestehen und über Thiol-Bindungen an die ersten und/oder zweiten Anschlußelektroden (3, 4) gebunden sind, die vorzugsweise Gold enthalten oder daraus bestehen.

12. Verwendung von Clustern (2), die jeweils einen metallischen Clusterkern (5) aus einem Übergangsmetall und vorzugsweise eine elektrisch isolierende Clusterhülle (6) aufweisen, als elektronischer Speicher oder zur Bildung von Ein-Elektronen-Transistoren,
**dadurch gekennzeichnet,**
**daß** die Cluster (2) derart elektrisch angeschlossen werden, daß sie unabhängig voneinander einzelweise elektrisch durch Einzel-Elektronen-Übergänge zwischen Cluster (2) und Anschlußelektrode (3, 4) modifiziert und abgefragt werden können, und daß die Größe der Clusterkerne (5) höchstens etwa 2,5 nm beträgt und/oder die Cluster (2) einen mittleren Durchmesser von 1 bis 5 nm aufweisen.

13. Verwendung nach Anspruch 12, **dadurch gekennzeichnet, daß** die Cluster (2) bei Raumtemperatur oder höheren Temperaturen eingesetzt werden.

14. Verwendung nach Anspruch 12 oder 13, **dadurch gekennzeichnet, daß** aus den Clustern (2) ein mikroelektronisches Bauelement (1) gemäß einem der Ansprüche 1 bis 11 gebildet wird,

15. Verfahren zur Herstellung eines mikroelektronischen, insbesondere gemäß einem der Ansprüche 1 bis 11 ausgebildeten Bauelements (1), wobei Cluster (2) mit einem metallischen Clusterkern (5) und vorzugsweise einer elektrisch isolierenden Clusterhülle (6) an erste und zweite Anschlußelektroden (3, 4) angeschlossen werden,
**dadurch gekennzeichnet,**
**daß** eine Vielzahl der Cluster (2) einzeln an die erste und zweite Anschlußelektrode (3, 4) derart angeschlossen werden, daß diese Cluster (2) unabhängig voneinander einzelweise elektrisch durch Einzel-Elek-tronen-Übergänge zwischen Cluster (2) und Anschlußelektrode (3, 4) modifiziert werden können, und
**daß** die ersten und zweiten Anschlußelektroden (3, 4) streifenartig ausgebildet und derart angeordnet werden, daß die ersten Anschlußelektroden (3) jeweils parallel zueinander verlaufen und die zweiten Anschlußelektroden (4) jeweils parallel zueinander und quer zu den ersten Anschlußelektroden (3) verlaufen,
wobei die Cluster (2) linien- oder reihenartig in einer Ebene bzw. in Vertiefungen angeordnet werden und/oder die zweiten Anschlußelektroden (4) in einer gemeinsamen Ebene beabstandet zu den ersten Anschlußelektroden (3) verlaufen,
wobei eine erste und eine zweite Anschlußelektrode (3, 4) an ihrem jeweiligen Kreuzungspunkt jeweils über einen einzigen Cluster (2) unmittelbar miteinander elektrisch in Kontakt gebracht werden.

16. Verfahren nach Anspruch 15, **dadurch gekennzeichnet, daß** die Cluster (2) im wesentlichen linien- bzw. reihenförmig auf den ersten Anschlußelektroden (3) angeordnet werden.

17. Verfahren nach Anspruch 15 oder 16, **dadurch gekennzeichnet, daß** die vorzugsweise aus Gold bestehenden, ersten und/oder zweiten Anschlußelektroden (3, 4) vorzugsweise mit einem thiolhaltigen Mittel, insbesondere Phenylendithiol, chemisch modifiziert oder versehen werden, um die die Cluster (2), insbesondere die Clusterkerne (5), chemisch an den ersten und/oder zweiten Anschlußelektroden (3, 4) zu binden, insbesondere über kovalente Gold-Schwefel-Bindungen.

18. Verfahren nach einem der Ansprüche 15 bis 17, **dadurch gekennzeichnet, daß** die zweiten Anschlußelektroden (4) separat gebildet und dann auf die Cluster (2) zur elektrischen Kontaktierung der Cluster (2) aufgepreßt und/oder gegen diese vorgespannt und/oder in der die Cluster (2) kontaktierenden Lage festgelegt werden.

## Claims

1. Microelectronic component (1), especially electronic memory, with a plurality of clusters (2) and with first and second connecting electrodes (3, 4), wherein the clusters (2) each have a metallic cluster nucleus (5) and preferably an electrically insulating cluster shell (6),
**characterized in**
**that** a plurality of said clusters (2) are each connected individually to a first and second connecting electrode (3, 4), such that individually these clusters (2) can be electrically modified or polled independently of each other, and
**that** the size of said metallic cluster nuclei (5) is at most approximately 2.5 nm and/or said clusters (2) have an average diameter of 1 to 5 nm.

2. Component according to claim 1, **characterized in that** the clusters (2) are arranged in lines or rows, especially in only one plane, or individually, especially in recesses.

3. Component according to claim 1 or 2, **characterized in that** said second connecting electrodes run parallel to each other, especially in a common plane spaced to said first connection electrodes (3).

4. Component according to claims 2 and 3, **characterized in that** the second connecting electrodes (4) run crosswise to the clusterlines and/or -rows, especially perpendicular to said second connecting electrodes.

5. Component according to any one of the preceding claims, **characterized in that** at least one of said first connecting electrodes and said second connecting electrodes (3, 4) are formed on front faces (17) of one layer structure (S) or two layer structures (S), especially are formed by vapour-deposition, wherein said at least one layer structure (S) comprises alternate layers preferably of on one hand at least one of GaAs and Ga₂O₃ and on the other hand of at least one of AlAs and Al₂O₃.

6. Component according to any one of the preceding claims, **characterized in that** at least one of said first connecting electrodes and said second connecting electrodes (3, 4) are at least one of pressed against said clusters (2), and/or stressed against said clusters, and/or fixed in a position contacting said clusters (2).

7. Component according to any one of the preceding claims, **characterized in that** the first and/or second connecting electrodes (3, 4) each form a tunnel contact with the contacted clusters (2).

8. Component according to any one of the preceding claims, **characterized in that** a first and a second connecting electrode (3, 4) each form, together with a bonded cluster (2), a single-electron transistor and/or are in electrical contact with each other by means of at most one cluster (2).

9. Component according to any one of the preceding claims, **characterized in that** at least one of said first connecting electrodes and said second connecting electrodes (3, 4) comprise a width (B) of essentially 50 to 125 % of the mean diameter of said clusters (2).

10. Component according to any one of the preceding claims, **characterized in that** said clusters (2) or said cluster nuclei (5) are bonded chemically, especially by covalent bonds and/or thiole-bonds, to at least one of said first connecting electrodes and said second connecting electrodes (3, 4).

11. Component according to any one of the preceding claims, **characterized in that** said cluster nuclei (5) contain gold or are composed of gold and are bonded by means ofthiole-bindings to at least one of said first connecting electrodes and said second connecting electrodes (3, 4), which preferably contain gold or are composed of gold.

12. Use of clusters (2), each comprising a metallic cluster nucleus (5) of a transient metal and preferably comprising an electrically insulating cluster shell (6), as electronic memory or for forming single-electron transistors,
**characterized in**
**that** the clusters (2) are electrically connected in such a way, that individually they can be electrically modified or polled independently of each other by single-electron transfers, and
**that** the size of said metallic cluster nuclei (5) equals at most approximately 2.5 nm and/or said clusters have an average diameter of 1 to 5 nm.

13. Use according to claim 12, **characterized in that** the clusters (2) are used during room temperature or higher temperatures.

14. Use according to claim 12 or 13, **characterized in that** out of the clusters (2) a microelectronic component is formed, according to one of the claims 1 to 11.

15. Method for fabricating a microelectronic component, especially a component (1) formed according to claims 1 to 11, wherein clusters (2) with a metallic cluster nucleus (5) and preferably an electrically insulating cluster shell (6) are connected to first and second connecting electrodes (3, 4),
**characterized in**
**that** a plurality of clusters (2) are connected individually to the first and second connecting electrode (3, 4), such that individually these clusters (2) can be electrically modified independently of each other through single-electron transfers between cluster (2) and connecting electrode (3, 4), and
**that** the first and second connecting electrodes (3, 4) are strip-shaped and arranged such that the first connecting electrodes (3) each run parallel to each other and the second connecting electrodes (4) each run parallel to each other and crosswise to the first connecting electrodes (3),
wherein the clusters (2) are arranged in lines or rows in one plane and/or in recesses, and/or the second connecting electrodes (4) run in a common plane spaced to the first connecting electrodes (3),
wherein a first and a second connecting electrode (3, 4) are each brought into electrical contact with each other at their respective intersecting point by means of a single cluster (2).

16. Method according to claim 15, **characterized in that** the clusters (2) are arranged onto the first connecting electrodes (3) substantially line- and/or row-like.

17. Method according to claim 15 or 16, **characterized in that** at least one of said first connecting electrodes and said second connecting electrodes (3, 4), preferably composed of gold, is chemically modified or prepared especially by means of phenylenditiol in order to bind chemically said clusters (2), especially the cluster nuclei (5) to the first and/or second connecting electrodes (3, 4), especially by covalent gold-sulfur-bonds.

18. Method according to Claim 15 to 17, **characterized in that** the second connecting electrodes (4) are formed separately and then pressed onto the clusters (2) for electrical bonding of the clusters, and/or stressed against said clusters, and/or fixed in a position contacting said clusters (2).

## Revendications

1. Composant micro-électronique (1), en particulier mémoire électronique, comprenant plusieurs clusters (2) et comprenant des premières et des deuxièmes électrodes de connexion (3, 4), les clusters (2) présentant respectivement un noyau de cluster métallique (5) et de préférence une enveloppe de cluster (6) procurant une isolation électrique, **caractérisé en ce qu'**une multitude des clusters (2) sont soumis à une connexion individuelle respectivement à une première et à une deuxième électrode de connexion (3, 4) de telle sorte que ces clusters (2) peuvent faire l'objet d'interrogations et de modifications électriques individuelles indépendamment les uns des autres, et **en ce que** la dimension du noyau de cluster (5) s'élève au maximum à environ 2,5 nm et/ou les clusters (2) présentent un diamètre moyen de 1 à 5 nm.

2. Composant électronique selon la revendication 1, **caractérisé en ce que** les clusters (2) sont disposés en lignes ou en rangs, en particulier dans un seul plan, ou de manière individuelle, en particulier dans des renfoncements.

3. Composant électronique selon la revendication 1 ou 2, **caractérisé en ce que** les deuxièmes électrodes de connexion (4) s'étendent parallèlement les unes aux autres, en particulier dans un plan commun, à l'écart des premières électrodes de connexion (3).

4. Composant électronique selon les revendications 2 et 3, **caractérisé en ce que** les deuxièmes électrodes de connexion (4) croisent les lignes, respectivement les rangs de clusters, en particulier s'étendent perpendiculairement à ces derniers.

5. Composant électronique selon l'une quelconque des revendications précédentes, **caractérisé en ce que** les premières et/ou les deuxièmes électrodes de connexion (3, 4) sont formés sur les côtés frontaux (17) d'une structure stratifiée (S) ou de deux structures stratifiées (S), en particulier par métallisation sous vide, la/les structures stratifiée(s) (S) étant formée(s) de préférence sur des couches alternantes d'une part de GaAs ou de Ga₂O₃ et d'autre part de AlAs ou de Al₂O₃.

6. Composant électronique selon l'une quelconque des revendications précédentes, **caractérisé en ce que** les premières et/ou les deuxièmes électrodes de connexion (3, 4) sont comprimées pour une mise en contact électrique contre les clusters (2) et/ou sont mises en état de précontrainte contre ces derniers et/ou sont fixées dans la couche de mise en contact avec les clusters (2).

7. Composant électronique selon l'une quelconque des revendications précédentes, **caractérisé en ce que** les premières et/ou les deuxièmes électrodes de connexion (3, 4) forment avec les clusters (2), avec lesquels elles entrent en contact, un contact de type tunnel.

8. Composant électronique selon l'une quelconque des revendications précédentes, **caractérisé en ce qu'**une première et une deuxième électrodes de connexion (3, 4) forment, de manière conjointe avec un cluster (2) mis en contact, respectivement un transistor mono-électronique et/ou entrent en contact électrique réciproque direct via au maximum un cluster (2).

9. Composant électronique selon l'une quelconque des revendications précédentes, **caractérisé en ce que** la largeur (B) des premières et/ou des deuxièmes électrodes de connexion (3, 4) représente essentiellement de 50 à 125 % du diamètre moyen des clusters (2).

10. Composant électronique selon l'une quelconque des revendications précédentes, **caractérisé en ce que** les clusters (2) ou les noyaux de clusters (5) sont liés par voie chimique, en particulier via des liaisons covalentes et/ou via des liaisons thiol, aux premières et/ou aux deuxièmes électrodes de connexion (3, 4).

11. Composant électronique selon l'une quelconque des revendications précédentes, **caractérisé en ce que** les noyaux de clusters (5) contiennent de l'or ou bien en sont constitués et sont reliés via des liaisons thiol aux premières et/ou aux deuxièmes électrodes de connexion (3, 4) qui de préférence contiennent de l'or ou en sont constituées.

12. Utilisation de clusters (2) qui présentent respectivement un noyau de cluster métallique (5) constitué par un métal de transition et de préférence une enveloppe de cluster (6) procurant une isolation électrique, comme mémoire électronique ou bien pour la formation de transistors mono-électroniques, **caractérisée en ce que** les clusters (2) sont soumis à une connexion électrique telle qu'ils peuvent faire l'objet d'une interrogation et d'une modification électrique individuelles indépendamment les uns des autres via des transitions mono-électroniques entre les clusters (2) et les électrodes de connexion (3, 4), et **en ce que** la dimension des noyaux de clusters (5) s'élève au maximum à environ 2,5 nm et/ou les clusters (2) présentent un diamètre moyen de 1 à 5 nm.

13. Utilisation selon la revendication 12, **caractérisée en ce que** les clusters (2) sont mis en oeuvre à la température ambiante ou à des températures élevées.

14. Utilisation selon la revendication 12 ou 13, **caractérisée en ce que**, à partir des clusters (2), on forme un composant micro-électronique (1) conformément à l'une quelconque des revendications 1 à 11.

15. Procédé pour la fabrication d'un composant micro-électronique (1) réalisé en particulier conformément à l'une quelconque des revendications 1 à 11, dans lequel des clusters (2) comprenant un noyau de cluster métallique (5) et de préférence une enveloppe de cluster (6) procurant une isolation électrique, sont connectés à une première et une deuxième électrode de connexion (3, 4), **caractérisé en ce qu'**une multitude de clusters (2) sont soumis à une connexion individuelle aux premières et aux deuxièmes électrodes de connexion (3, 4) telle que ces clusters (2) peuvent faire l'objet d'une modification électrique individuelle indépendamment les uns des autres via des transitions mono-électroniques entre les clusters (2) et les électrodes de connexion (3, 4), et **en ce que** les premières et deuxièmes électrodes de connexion (3, 4) sont réalisées en forme de bandes et sont disposées de telle sorte que les premières électrodes de connexion (3) s'étendent de manière respective parallèlement les unes aux autres et de telle sorte que les deuxièmes électrodes de connexion (4) s'étendent de manière respective parallèlement les unes aux autres et transversalement par rapport aux premières électrodes de connexion (3), procédé dans lequel les clusters (2) sont disposés en lignes ou en rangs dans un seul plan, respectivement dans des renfoncements et/ou les deuxièmes électrodes de connexion (4) s'étendent dans un plan commun à l'écart des premières électrodes de connexion (3), une première et une deuxième électrode de connexion (3, 4) étant amenées en contact électrique réciproque de manière directe à chacun de leurs points de croisement respectivement via un seul cluster (2).

16. Procédé selon la revendication 15, **caractérisé en ce que** les clusters (2) sont disposés essentiellement en ligne, respectivement en rangs sur les premières électrodes de connexion (3).

17. Procédé selon la revendication 15 ou 16, **caractérisé en ce que** les premières et/ou les deuxièmes électrodes de connexion (3, 4), constituées de préférence d'or sont soumises à une modification chimique ou sont munies d'un revêtement chimique avec un agent comprenant un ou plusieurs groupes thiol, en particulier du phénylènedithiol, pour relier les clusters (2), en particulier les noyaux de clusters (5), par voie chimique aux premières et/ou aux deuxièmes électrodes de connexion (3, 4), en particulier via des liaisons covalentes or-soufre.

18. Procédé selon l'une quelconque des revendications 15 à 17, **caractérisé en ce que** les deuxièmes électrodes de connexion (4) sont réalisées séparément avant d'être appliquées par pression sur les clusters (2) pour une mise en contact électrique avec les clusters (2) et/ou avant de venir se disposer contre ces derniers en état de précontrainte et/ou avant d'être fixées dans leur couche de mise en contact avec les clusters (2).
